# EUROPÄISCHE PATENTSCHRIFT

(11) **EP 0 677 916 B1**
(45) Veröffentlichungstag und Bekanntmachung des Hinweises auf die Patenterteilung: **16.09.1998**
(21) Anmeldenummer: 95105341.2
(22) Anmeldetag: 08.04.1995
(51) Int. Cl.: H02M 7/00

(54) **Stromrichteranlage mit flüssigkeits- oder luftgekühlten Leistungshalbleitern und Gleichspannungszwischenkreis**
Power converter assembly with liquid- or air-cooled power semiconductors and DC circuit
Ensemble convertisseur de puissance avec semi-conducteurs de puissance et circuit à courant continu refroidis par liquide ou par air

(30) Priorität: 15.04.1994 DE 4412990
(43) Veröffentlichungstag der Anmeldung: 18.10.1995
(73) Patentinhaber: ABB Daimler-Benz Transportation (Technology) GmbH, 13627 Berlin (DE)
(72) Erfinder: Krämer, Wilhelm, D-69207 Sandhausen (DE); Reimers, Hans Heinrich, D-68167 Mannheim (DE); Kehl, Christoph, D-68526 Ladenburg (DE); Klaiber, Wolfram, D-69502 Hemsbach (DE)
(74) Vertreter: Rupprecht, Klaus, Dipl.-Ing.

(56) Entgegenhaltungen:
- DE-A- 4 232 763
- DE-U- 9 302 586
- DE-U- 9 314 286

## Beschreibung

Die Erfindung bezieht sich auf eine Stromrichteranlage mit flüssigkeits- oder luftgekühlten Leistungshalbleitern und Gleichspannungszwischenkreis gemäß dem Oberbegriff des Anspruchs 1 und eignet sich insbesondere zur Anwendung bei Wechselrichtern für schienengebundene Fahrzeuge.

Eine solche Stromrichteranlage mit flüssigkeitsgekühlten Leistungshalbleitern ist aus der DE-A 40 20 026 bekannt. Dort wird eine Stromrichteranlage mit einem eine Kondensatorbatterie aufweisenden Gleichspannungszwischenkreis vorgeschlagen, bestehend aus mindestens einem Stromrichtermodul, dessen elektrische Modulanschlüsse in einer Reihe angeordnet und mit einem ersten induktivitätsarmen Verbindungsschienensystem kontaktierbar sind. Die Kondensatorbatterie ist dem Stromrichtermodul mechanisch zugeordnet und ihre elektrischen Anschlüsse liegen an einem zweiten, die Gleichspannungszwischenkreis-Leitungen enthaltenden, senkrecht zum ersten Verbindungsschienensystem angeordneten, induktivitätsarmen Verbindungsschienensystem, das mit dem ersten Verbindungsschienensystem elektrisch in Verbindung steht. Bei einer mindestens zwei Stromrichtermodule enthaltenden Anlage ist die Gesamt-Kondensatorbatterie des Gleichspannungszwischenkreises in einzelne, jeweils den einzelnen Stromrichtermodulen mechanisch zugeordnete Teil-Kondensatorbatterien aufgeteilt und die zweiten Verbindungsschienensysteme benachbarter Module sind jeweils über elektrische Kupplungen miteinander verbunden.

Der Erfindung liegt die Aufgabe zugrunde, eine Stromrichteranlage mit flüssigkeits- oder luftgekühlten Leistungshalbleitern und Gleichspannungszwischenkreis der eingangs genannten Art anzugeben, die äußerst kompakt aufgebaut ist und bei der insbesondere die elektrischen Verbindungen zwischen der Kondensatorbatterie des Gleichspannungszwischenkreises und den Leistungshalbleitern auf kürzestem Wege realisiert sind.

Diese Aufgabe wird in Verbindung mit den Merkmalen des Oberbegriffes erfindungsgemäß durch die im Kennzeichen des Anspruchs 1 angegebenen Merkmale gelöst.

Die mit der Erfindung erzielbaren Vorteile bestehen insbesondere darin, daß keine eigene Verschienung für die Kondensatorbatterie des Gleichspannungszwischenkreises erforderlich ist. Das parallel zur Kühlschiene verlaufende einzige stirnseitige Verbindungsschienensystem umfaßt sowohl die Zwischenkreisschienen des Gleichspannungszwischenkreises inklusive der elektrischen Kondensatoranschlüsse als auch bedarfsweise die Schienen zur Bildung des Lastanschlusses (Wechselspannungsanschlusses). Die Kondensatoren sind direkt mit den Zwischenkreisschienen und auf extrem kurzem Weg mit den elektrischen Anschlüssen der Leistungshalbleiter verbunden. Durch den Wegfall einer eigenen Verschienung für die Kondensatorbatterie verringern sich vorteilhaft die durch die Gesamtverschienung bedingten Induktivitäten. Dies hat vorteilhafte Auswirkungen auf die Dimensionierung der zur Funktionsfähigkeit der Leistungshalbleiter erforderlichen Beschaltungen und auf die durch diese Beschaltungen verursachten Verlustleistungen. Bei vielen Anwendungsfällen können die Beschaltungen sogar ganz entfallen, da aufgrund der sehr niedrigen Induktivität der Verschienung auch ohne Beschaltung nur geringe Schaltüberspannungen an den Leistungshalbleitern auftreten. Dies wirkt sich vorteilhaft auf die Lebensdauer der Leistungshalbleiter und der daran angeschlossenen Fahrmotoren aus. Einen großen Vorteil stellt die doppelseitige Nutzung der Kühlschiene und im Zusammenhang hiermit die Aufteilung der Kondensatorbatterie des Gleichspannungszwischenkreises in zwei Teil-Kondensatorbatterien dar, was in Verbindung mit dem einzigen Verbindungsschienensystem zu einem äußerst kompakten, d.h. "verdichteten" Aufbau der Stromrichteranlage führt.

Die Erfindung wird nachstehend anhand der in der Zeichnung dargestellten Ausführungsbeispiele erläutert. Es zeigen:
- Figur 1: eine Seitenansicht der Stromrichteranlage,
- Figur 2: eine Stirnseite der Stromrichteranlage ohne Verschienung und Ansteuerung,
- Figur 3: eine Sicht auf die Oberseite der Stromrichteranlage ohne Verschienung und Ansteuerung,
- Figur 4: eine perspektivische Ansicht der Stromrichteranlage ohne Gehäuseteile, Verschienung und Ansteuerung,
- Figur 5: einen Schnitt durch das Verbindungsschienensystem,
- Figur 6: einen Schnitt durch die Kühlschiene,
- Figur 7: eine perspektivische Ansicht der Stromrichteranlage mit Gehäuseteilen und Verschienung,
- Figur 8: eine perspektivische Ansicht einer Stromrichteranlage mit einem alternativen Verbindungsschienensystem,
- Figur 9: einen Schnitt durch die Stromrichteranlage mit alternativem Verbindungsschienensystem,
- Figur 10: eine alternative Kontaktierung der Verschienung mit einem Leistungshalbleiteranschluß.

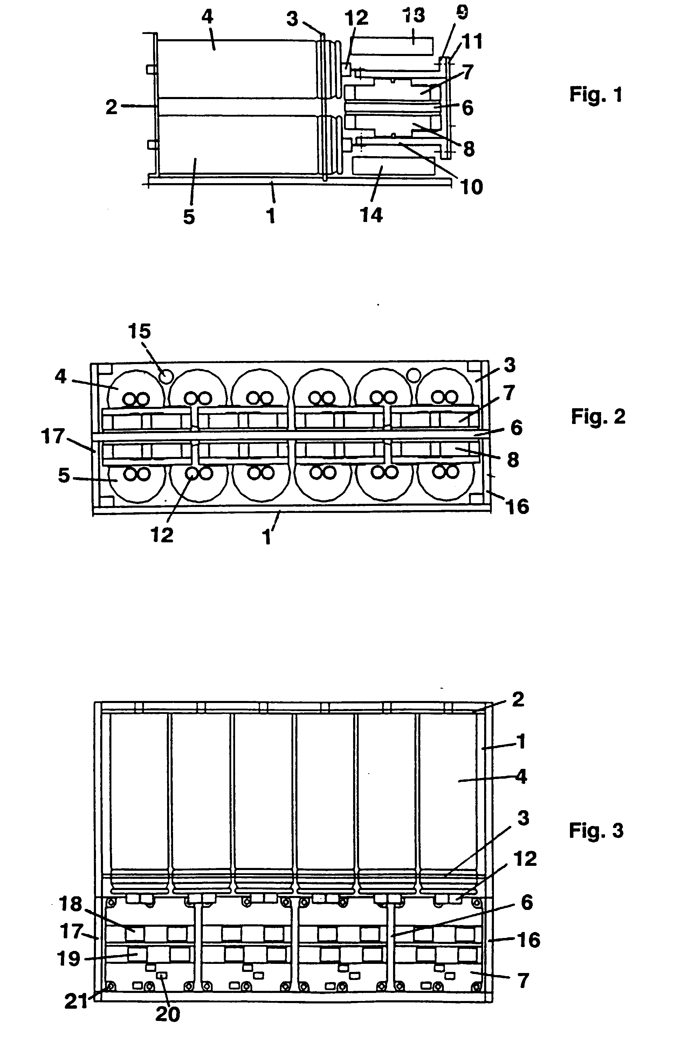

In Figur 1 ist eine Seitenansicht der Stromrichteranlage dargestellt. Die Stromrichteranlage (Wechselrichter) und die Kondensatorbatterie des Gleichspannungszwischenkreises sind auf einer Bodenplatte 1 aufgebaut. Zwei rechtwinklig bezüglich der Bodenplatte 1 gebogene Kondensatorhalterungen 2, 3 dienen zur axialen Befestigung der einzelnen Kondensatoren der in zwei Ebenen übereinander angeordneten Teil-Kondensatorbatterien 4, 5. Auf der Ebene zwischen beiden Teil-Kondensatorbatterien 4, 5 und zu den Kondensatoranschlüssen 12 hingewandt, befindet sich eine Kühlschiene 6. Diese aus einem im Querschnitt rechteckförmigen Strangpreßprofil hergestellte Kühlschiene 6 weist eine Vielzahl von Kühlflüssigkeitskanälen auf, die vorzugsweise von Brauchwasser durchflossen werden.

Beide Hauptoberflächen der Kühlschiene 6 sind thermisch mit Leistungshalbleitern 7, 8, vorzugsweise IGBT-Modulen mit jeweils zwei Ventilen, kontaktiert. Die elektrische Verschaltung der Leistungshalbleiter 7, 8 untereinander und mit den Kondensatoren der Kondensatorbatterien 4, 5 erfolgt über ein parallel zur Kühlschiene 6 angeordnetes Verbindungsschienensystem (Sandwichverschienung), bestehend aus einer ersten und einer zweiten Längsverschienung und einer Querverschienung. Die erste Längsverschienung 9 verbindet Anschlüsse der ersten Leistungshalbleiter 7 untereinander und mit den Kondensatoren der ersten Teil-Kondensatorbatterie 4, die zweite Längsverschienung 10 verbindet Anschlüsse der zweiten Leistungshalbleiter 8 untereinander und mit den Kondensatoren der zweiten Teil-Kondensatorbatterie 5. Die Querverschienung 11 verbindet insbesondere die Gleichspannungspotentiale beider Längsverschienungen untereinander, so daß ein Gesamt-Gleichspannungszwischenkreis gebildet wird.

In Figur 1 sind des weiteren die Ansteuerplatinen 13 für die ersten Leistungshalbleiter 7 und die Ansteuerplatinen 14 für die zweiten Leistungshalbleiter 8 zu erkennen. Vorteilhaft sind diese Ansteuerplatinen 13 in unmittelbarer Nähe der Leistungshalbleiter (vorzugsweise IGBT-Ventile) angeordnet.

Wie aus Figur 1 hervorgeht, ist die Stromrichteranlage allseitig aufstellbar, lediglich die Stirnseite muß für den elektrischen Anschluß zugänglich sein. Selbst eine senkrechte Montage ist möglich. Insbesondere ist die Stromrichteranlage "stapelfähig", d.h. es können mehrere derartige Stromrichteranlagen (Module) übereinander montiert werden, wobei alle Leistungsanschlüsse (DC-Anschlüsse, AC-Anschlüsse) stirnseitig zugänglich sind. Andererseits weist gerade die sehr flache Bauweise der Stromrichteranlage Vorteile auf, wenn die Stromrichteranlage beispielsweise in Unterflur-Bauweise bei Schienenfahrzeugen eingesetzt wird, so daß sich bei dieser Bauweise eine Anordnung der einzelnen Module nebeneinander empfiehlt. Bei beiden Bauweisen (Stapel- oder Unterflur-Bauweise) werden Durchstecksensoren (Stromwandler) und/oder Spannungswandler für die Regelung der Stromrichteranlage an der Stirnseite bzw. seitlich angebracht.

In Figur 2 ist eine Stirnansicht der Stromrichteranlage ohne Verschienung und Ansteuerung dargestellt. Es sind die Bodenplatte 1, die Kondensatorhalterung 3, die jeweils aus sechs einzelnen Kondensatoren bestehenden Teil-Kondensatorbatterien 4, 5, die Kühlschiene 6 und die Leistungshalbleiter 7, 8 zu erkennen, wobei vier erste Leistungshalbleiter 7 und vier zweite Leistungshalbleiter 8 vorhanden sind. Insbesondere geht aus Figur 2 die spiegelbildliche Anordnung der Leistungshalbleiter und der beiden Teil-Kondensatorbatterien hervor. Montageösen 15 innerhalb der Kondensatorhalterung 3 erleichtern den Einbau der Stromrichteranlage. Zur Arretierung der Kühlschienen dienen Kühlschienenhalterungen 16, 17.

In Figur 3 ist eine Sicht auf die Oberseite der Stromrichteranlage ohne Verschienung und Ansteuerung dargestellt. Es sind die Bodenplatte 1, die Kondensatorhalterungen 2, 3 mit Kondensatoranschlüssen 12, die Teil-Kondensatorbatterie 4, die Kühlschiene 6 mit Kühlschienenhalterungen 16, 17 und die ersten Leistungshalbleiter 7 zu erkennen. Jeder Leistungshalbleiter weist Kollektoren 18, Emitter 19 und Steueranschlüsse 20 auf. Die Befestigung der Leistungshalbleiter (Module) erfolgt über Montagebohrungen 21 unmittelbar auf der Kühlschiene 6.

Insbesondere geht aus Figur 3 hervor, daß die Verbindung von elektrischen Anschlüssen nebeneinander angeordneter Leistungshalbleiter zur Bildung von Lastanschlüssen der Stromrichteranlage (Wechselrichter) in sehr einfacher Weise möglich ist.

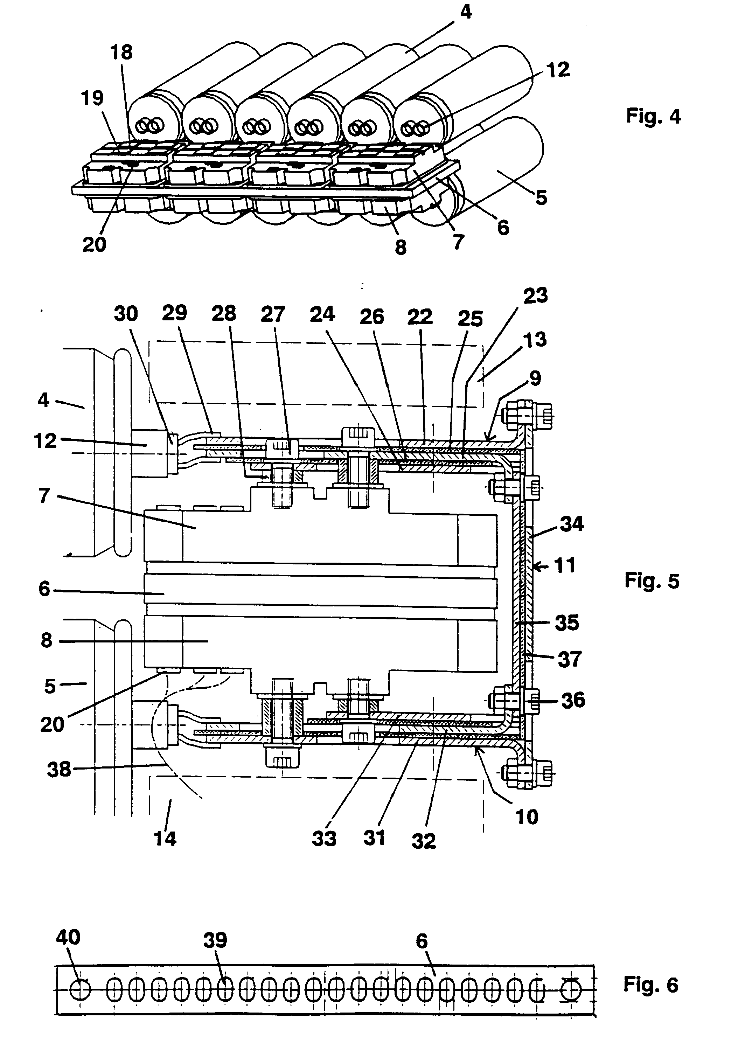

In Figur 4 ist eine perspektivische Ansicht der Stromrichteranlage ohne Gehäuseteile, Verschienung und Ansteuerung dargestellt. Es sind die Teil-Kondensatorbatterien 4, 5, die Kondensatoranschlüsse 12, die Kühlschiene 6 und die Leistungshalbleiter 7, 8 mit Kollektoren 18 , Emittern 19 und Steueranschlüssen 20 zu erkennen.

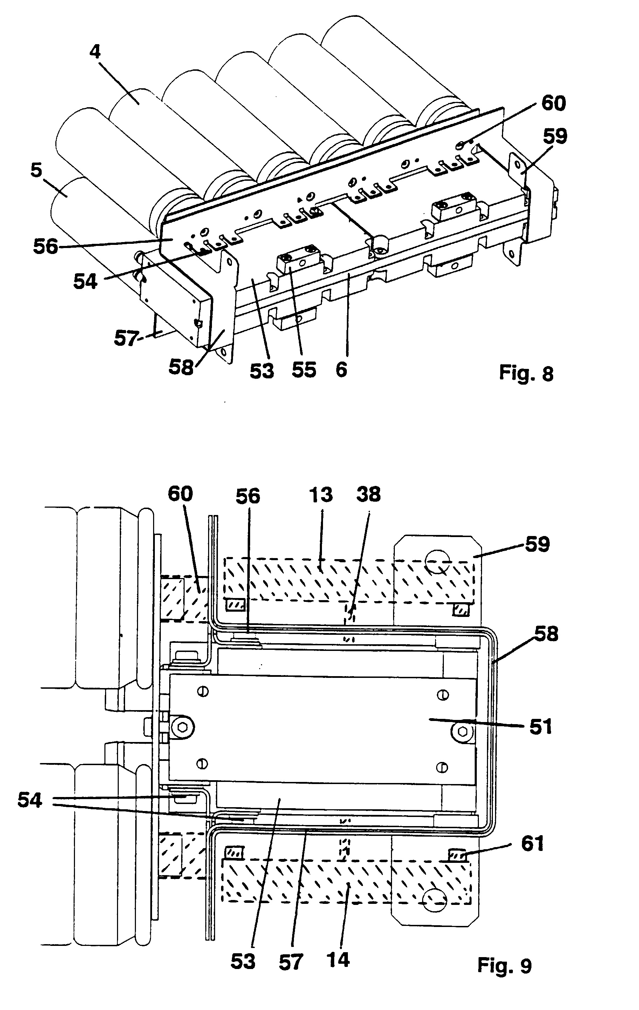

In Figur 5 ist ein Schnitt durch das Verbindungsschienensystem dargestellt. Es ist der U-förmige Querschnitt des Verbindungsschienensystems mit der stirnseitigen Querverschienung 11 als Basisschenkel und den beiden Längsverschienungen 9, 10 als Seitenschenkel zu erkennen, wobei sich die Kühl schiene 6 mit den beidseitig thermisch kontaktierten Leistungshalbleitern 7, 8 zentral innerhalb des vom Verbindungsschienensystem umschlossenen Raumes befindet. Das Verbindungsschienensystem ist vorzugsweise als Sandwichverschienung ausgeführt. Die beiden Längsverschienungen 9, 10 sind jeweils fünfschichtig und die Querverschienung 11 ist dreischichtig aufgebaut. Im einzelnen weist die erste Längsverschienung 9 eine erste DC-Schiene 22, eine zweite DC-Schiene 23 und mindestens eine AC-Schiene 24 auf, wobei sich Isolierschichten 25, 26 zwischen den aus einem elektrisch gut leitenden Material - vorzugsweise aus Aluminium oder Kupfer - bestehenden Schichten 22 bis 24 befinden. Die zweite Längsverschienung 10 ist in gleicher Weise aufgebaut und weist eine erste DC-Schiene 31, eine zweite DC-Schiene 32 und mindestens eine AC-Schiene 34 auf. Alternativ können die Längsverschienungen 9, 10 siebenschichtig und die Querverschienung 11 fünfschichtig aufgebaut sein. Die zusätzlichen Schichten werden durch Außenisolationen gebildet, so daß die Verschienungen jeweils außenisoliert sind und enge Abstände zu benachbarten Baukomponenten eingehalten werden können. Die Kontaktierung zwischen den elektrischen Anschlüssen der Leistungshalbleiter (Kollektoren 18, Emitter 19) und den Schienen der Längsverschienungen 9, 10 erfolgt mittels Verschraubungen 27, wobei Distanzrollen 28 die unterschiedlichen Abstände zwischen den einzelnen Leistungshalbleiter-Anschlüssen und den Schienen ausgleichen. Alternativ zum vorstehend erläuterten Aufbau können die DC-Schienen 22, 34, 31 und 23, 35, 32 auch jeweils einstückig ausgebildet und entsprechend gebogen sein (siehe hierzu auch die Variante gemäß den Figuren 8, 9).

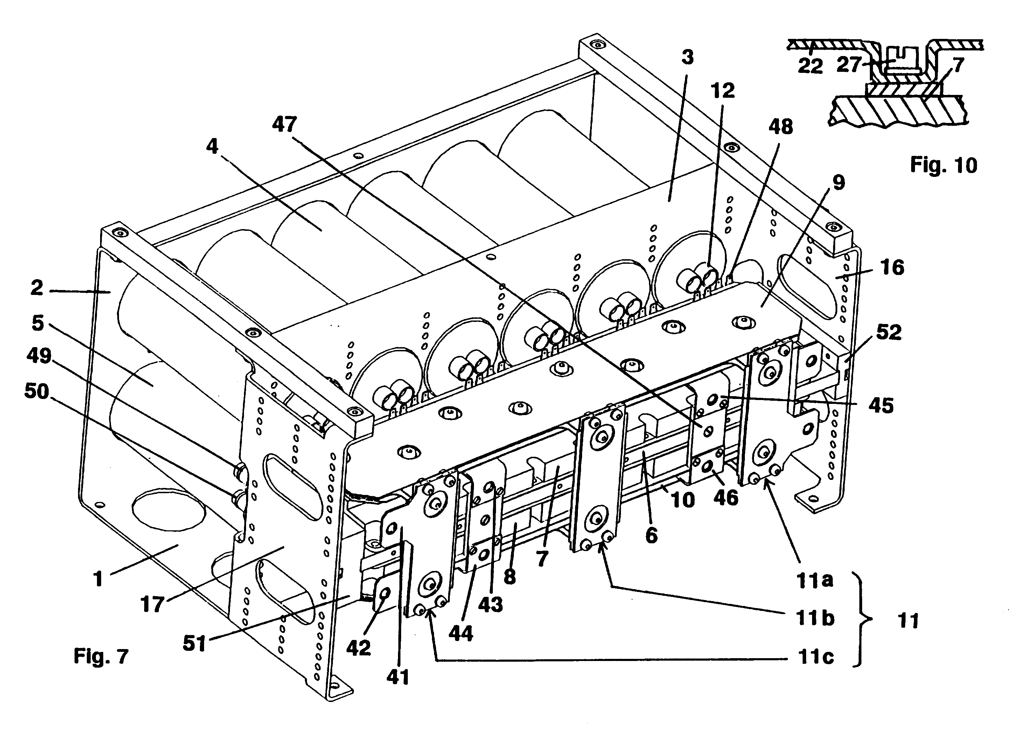

Die DC-Schienen 22, 23 bzw. 31, 32 befinden sich jeweils auf der Höhe der Kondensatoranschlüsse 12 der Teil-Kondensatorbatterien 4 bzw. 5, so daß ein unmittelbarer Anschluß zwischen den einzelnen Kondensatoren der Kondensatorbatterien und dem Gleichspannungszwischenkreis über Litzen 29 und Stecker 30 erfolgen kann. Alternativ hierzu können auch die DC-Schienen 22, 23 mit Steckkontakten (siehe Ziffer 48 in Figur 7) versehen sein. Zur Bildung der Drehstrom-Lastanschlüsse sind die AC-Schienen 24, 33 mit winkelförmigen stirnseitigen Verlängerungen versehen (siehe AC-Anschlüsse 43 bis 46 in Figur 7).

Vorstehend wird davon ausgegangen, daß zur Bildung von Lastanschlüssen die elektrischen Anschlüsse von auf derselben Hauptoberfläche der Kühlschiene 6 angeordneten Leistungshalbleitern miteinander verbunden werden, wodurch sich die AC-Schienen 24, 33 ergeben. Es ist alternativ hierzu möglich, die elektrischen Anschlüsse von zwei spiegelbildlich Rücken an Rücken auf beiden Hauptoberflächen der Kühlschiene angeordneten Leistungshalbleiter miteinander zu verbinden. Bei dieser Alternative werden demnach die Anschlüsse von ersten und zweiten Leistungshalbleitern 7 und 8 miteinander verbunden, um Lastanschlüsse zu erhalten. Dementsprechend ist die Querverschienung ebenfalls fünfschichtig bzw. siebenschichtig ausgebildet (drei Leiterschichten und zwei bzw. vier Isolierschichten) und enthält zusätzliche AC-Schichten als Brücken zwischen zwei spiegelbildlich angeordneten Leistungshalbleitern zur Bildung der Lastanschlüsse.

Die Verbindung der DC-Schienen 22 und 31 bzw. 23 und 32 mit DC-Schienen 34 bzw. 35 der Querverschienung 35 erfolgt über Verschraubungen 36. Eine Isolierschicht 37 dient zur elektrischen Trennung der beiden DC-Schienen 34, 35.

Zur elektrischen Verbindung der Steueranschlüsse 20 der Leistungshalbleiter mit den Ansteuerplatinen 13, 14 dienen Koaxialleitungen 38.

Aus Figur 5 geht insbesondere hervor, daß vorteilhaft keine eigene Kondensatorverschienung notwendig ist, sondern daß ein direkter Anschluß der Kondensatoren an den Gleichstromzwischenkreis erfolgt.

Alternativ zur vostehend erläuterten Kontaktierung zwischen den elektrischen Anschlüssen der Leistungshalbleiter 7 und den Schienen der Längsverschienung über Distanzrollen 28 ist es auch möglich, die einzelnen Schienen derart auszubilden, daß Durchzüge entstehen und die Distanzrollen entbehrlich sind. In Figur 10 ist eine derartige alternative Kontaktierung der Verschienung mit einem Leistungshalbleiteranschluß gezeigt. Zur Bildung eines Durchzuges ist die DC-Schiene 22 U-förmig abgebogen und der Basisschenkel des U-förmigen Bogens wird mittels der Verschraubung 27 an den elektrischen Anschluß des Leistungshalbleiters 7 gepreßt.

In Figur 6 ist ein Schnitt durch die Kühlschiene dargestellt. Wie zu erkennen ist, weist die Kühlschiene 6 eine Vielzahl paralleler Kühlflüssigkeitskanäle 39 auf. Zur Befestigung der Kühlschiene an den Kühlschienenhalterungen 16, 17 dienen Montagebohrungen 40.

In Figur 7 ist eine perspektivische Ansicht der Stromrichteranlage mit Gehäuseteilen und Verschienung dargestellt. Im einzelnen sind die Bodenplatte 1, die beiden Kondensatorhalterungen 2 (= Rückenplatte) und 3, die Kühlschienenhalterungen 16, 17, die Kühlschiene 6 mit Kühlflüssigkeit-Zulauf 49, Kühlflüssigkeit-Ablauf 50, Kühlflüssigkeit-Verteilkopf 51 und Kühlflüssigkeit-Umlenkkopf 52, die Leistungshalbleiter 7, 8, die beiden Teil-Kondensatorbatterien 4, 5 mit Kondensatoranschlüssen 12, die Längsverschienungen 9, 10 mit Steckkontakten 48 zum Anschluß der Kondensatoren und die Querverschienung 11, bestehend aus drei voneinander getrennten Einzel-Querverschienungen 11a, 11b, 11c, zu erkennen, wobei die Querverschienungen 11a und 11c mit DC-Anschlüssen 41, 42 versehen sind und sich AC-Anschlüsse (Lastanschlüsse) 43, 44, 45, 46 in der Ebene der Querverschienung befinden. Zur Erhöhung der mechanischen Stabilität sind je zwei AC-Anschlüsse über Isolierplatten 47 miteinander verbunden, wobei diese Isolierplatten mit der Kühlschiene 6 verschraubt sind.

In Figur 8 ist eine perspektivische Ansicht einer Stromrichteranlage mit einem alternativen Verbindungsschienensystem dargestellt. Die Anordnung der Teil-Kondensatorbatterien 4, 5 und der Kühlschiene 6 ist wie vorstehend unter den Figuren 1 bis 7 beschrieben. Es werden jedoch Leistungshalbleiter 53 mit anders angeordneten DC-Anschlüssen 54 und AC-Anschlüssen 55 eingesetzt, so daß die erste Längsverschienung 56, die zweite Längsverschienung 57 und die Querverschienung 58 dementsprechend unterschiedlich zu den Figuren 1 bis 7 ausgebildet sind. Die Längsverschienungen 56, 57 sind nunmehr senkrecht zu den Hauptoberflächen der Leistungshalbleiter 53 angeordnet. Es sind direkte Kondensatoranschlüsse 60 unter Verwendung von Kontaktsteckern und ohne flexible Litzen möglich, wodurch die Induktivität der Gesamtanordnung nochmals gesenkt und die Montage vereinfacht wird. Hierdurch ergeben sich Kostenvorteile. Mit Ziffer 59 sind laschenförmige DC-Anschlüsse 59 bezeichnet, die von der Querverschienung abgebogen sind. Für die AC-Anschlüsse ist bei dieser Variante überhaupt keine Verschienung notwendig. Wie zu erkennen ist, sind DC- und AC-Anschlüsse vorteilhaft von der Stirnseite der Stromrichteranlage aus zugänglich. Ferner ist zu erkennen, daß die Verschienung 56/57/58 einstückig ausgebildet und dementsprechend gekantet ist.

In Figur 9 ist ein Schnitt durch die Stromrichteranlage mit alternativem Verbindungsschienensystem dargestellt. Es sind insbesondere die aus Längsverschienungen 56, 57 und Querverschienung 58 bestehende Verschienung, die Leistungshalbleiter 53, die DC-Anschlüsse 54 (= Anschlüsse der Leistungshalbleiter 53 mit den Längsverschienungen 56, 57), die Kondensatoranschlüsse 60 (= Steckkontakte zwischen Kondensatoren und Längsverschienungen 56, 57), die laschenförmigen DC-Anschlüsse 59 (für den externen Anschluß) und der Verteilkopf 51 für die Kühlschiene 6 zu erkennen.

Des weiteren ist die Lage der Ansteuerplatinen 13, 14 skizziert. Diese Ansteuerplatinen 13, 14 können beispielse auf Stützstäben 61 aus einem Isoliermaterial montiert sein, wobei diese Stützstäbe 61 mit den Kühlschienenhalterungen 16, 17 verbunden sind. Die Leitungen 38 zwischen den Ansteuerplatinen 13, 14 und den Leistungshalbleitern 53 sind vorteilhaft äußerst kurz.

## Patentansprüche

1. Stromrichteranlage mit flüssigkeits- oder luftgekühlten Leistungshalbleitern und Gleichspannungszwischenkreis, wobei die Kondensatorbatterie des Gleichspannungszwischenkreises in zwei übereinanderliegende Teil-Kondensatorbatterien aufgeteilt ist und jede Teil-Kondensatorbatterie aus mehreren nebeneinanderliegenden Kondensatoren besteht, dadurch gekennzeichnet, daß die Leistungshalbleiter auf beiden Hauptoberflächen einer Kühlschiene (6) angeordnet sind, welche sich an der Stirnseite der Teil-Kondensatorbatterien befindet, daß eine erste, parallel zu den Hauptoberflächen der Kühlschiene verlaufende, mehrschichtig aufgebaute Längsverschienung (9,56) mit elektrischen Anschlüssen der ersten Teil-Kondensatorbatterie (4) und den elektrischen Anschlüssen der auf der ersten Hauptoberfläche der Kühlschienen angeordneten ersten Leistungshalbleiter (7,53) verbunden ist, daß eine zweite, parallel zu den Hauptoberflächen der Kühlschiene verlaufende, mehrschichtig aufgebaute Längsverschienung (10,57) mit den elektrischen Anschlüssen der zweiten Teil-Kondensatorbatterie (5) und den elektrischen Anschlüssen der auf der zweiten Hauptoberfläche der Kühlschiene angeordneten zweiten Leistungshalbleiter (8,53) verbunden ist, und daß eine senkrecht zu den Längsverschienungen verlaufende, mehrschichtig aufgebaute Querverschienung (11,58) die Gleichspannungspotentiale beider Längsverschienungen verbindet, wobei das aus den beiden Längsverschienungen und der Querverschienung bestehende Verbindungsschienensystem sowie die beiden Teil-Kondensatorbatterien jeweils parallel zur Kühlschiene verlaufen.

2. Stromrichteranlage nach Anspruch 1, dadurch gekennzeichnet, daß die Längsverschienungen (9,10) neben den zur Bildung des Gleichspannungszwischenkreises erforderlichen Schienen (22,23,31,32) zusätzliche Schienen (24,33) für die Bildung von Lastanschlüssen aufweisen.

3. Stromrichteranlage nach Anspruch 2, dadurch gekennzeichnet, daß die Querverschienung (11) zusätzliche Schienen für die Bildung von Lastanschlüssen aufweist.

4. Stromrichteranlage nach einem der Ansprüche 1 bis 3, dadurch gekennzeichnet, daß Längsverschienungen (9,10,56,57) und Querverschienung (11,58) einstückig durchgängig ausgebildet sind.

5. Stromrichteranlage nach einem der Ansprüche 1 bis 3, dadurch gekennzeichnet, daß die elektrischen Verbindungen zwischen den Längsverschienungen (9,10) und der Querverschienung (11) über Verschraubungen (36) erfolgen.

6. Stromrichteranlage nach einem der Ansprüche 1 bis 5, dadurch gekennzeichnet, daß das Verbindungsschienensystem als Sandwichsystem ausgebildet ist, bestehend aus mehreren durch Isolierschichten (25,26,37) voneinander getrennten elektrisch leitenden Schienen (22 bis 24, 31 bis 35).

7. Stromrichteranlage nach einem der Ansprüche 1 bis 6, dadurch gekennzeichnet, daß das Verbindungsschienensystem stirnseitige Laschen (59) für den externen Anschluß aufweist.

8. Stromrichteranlage nach einem der Ansprüche 1 bis 7, dadurch gekennzeichnet, daß die elektrischen Anschlüsse der Leistungshalbleiter (7,8,53) über Distanzrollen (28) mit dem Verbindungsschienensystem verbunden sind.

9. Stromrichteranlage nach einem der Ansprüche 1 bis 7, dadurch gekennzeichnet, daß die elektrischen Anschlüsse der Leistungshalbleiter über Durchzüge mit dem Verbindungsschienensystem verbunden sind.

10. Stromrichteranlage nach einem der Ansprüche 1 bis 9, gekennzeichnet durch ein Gehäuse, bestehend aus einer Bodenplatte (1) mit Kondensatorhalterungen (2,3) und Kühlschienenhalterungen (16,17).

## Claims

1. Converter system having liquid-cooled or air-cooled power semiconductors and a DC intermediate circuit, the capacitor bank of the DC intermediate circuit being split into two partial capacitor banks which are located one above the other and each partial capacitor bank comprising a plurality of capacitors which are located alongside one another, characterized in that the power semiconductors are arranged on the two main surfaces of a cooling rail (6) which is located at the end of the partial capacitor banks, in that a first longitudinal rail system (9, 56), which runs parallel to the main surfaces of the cooling rail and is constructed with a number of layers, is connected to electrical connections of the first partial capacitor bank (4) and to the electrical connections of the first power semiconductors (7, 53), which are arranged on the first main surface of the cooling rails, in that a second longitudinal rail system (10, 57), which runs parallel to the main surfaces of the cooling rail and is constructed with a number of layers, is connected to the electrical connections of the second partial capacitor bank (5) and to the electrical connections of the second power semiconductors (8, 53), which are arranged on the second main surface of the cooling rail, and in that a transverse rail system (11, 58) which runs at right angles to the longitudinal rail system and is constructed with a number of layers connects the DC potentials of both longitudinal rail systems, the connecting rail system, which comprises the two longitudinal rail systems and the transverse rail system, as well as the two partial capacitor banks each running parallel to the cooling rail.

2. Converter system according to Claim 1, characterized in that in addition to the rails (22, 23, 31, 32) required to form the DC intermediate circuit, the longitudinal rail systems (9, 10) have additional rails (24, 33) for forming load connections.

3. Converter system according to Claim 2, characterized in that the transverse rail system (11) has additional rails for forming load connections.

4. Converter system according to one of Claims 1 to 3, characterized in that longitudinal rail systems (9, 10, 56, 57) and the transverse rail system (11, 58) are designed such that they are all integral.

5. Converter system according to one of Claims 1 to 3, characterized in that the electrical connections between the longitudinal rail systems (9, 10) and the transverse rail system (11) are made via screw connections (36).

6. Converter system according to one of Claims 1 to 5, characterized in that the connecting rail system is designed as a sandwich system, comprising a plurality of electrically conductive rails (22 to 24, 31 to 35) which are isolated from one another by means of insulating layers (25, 26, 37).

7. Converter system according to one of Claims 1 to 6, characterized in that the connecting rail system has end lugs (59) for external connection.

8. Converter system according to one of Claims 1 to 7, characterized in that the electrical connections of the power semiconductors (7, 8, 53) are connected to the connecting rail system via spacer rollers (28).

9. Converter system according to one of Claims 1 to 7, characterized in that the electrical connections of the power semiconductors are connected to the connecting rail system via passages.

10. Converter system according to one of Claims 1 to 9, characterized by a housing comprising a baseplate (1) with capacitor mountings (2, 3) and cooling rail mountings (16, 17).

## Revendications

1. Ensemble convertisseur avec semi-conducteurs de puissance et circuit intermédiaire à courant continu, à refroidissement par liquide ou par air, la batterie de condensateurs du circuit intermédiaire à courant continu étant subdivisée en deux batteries partielles superposées de condensateurs et chaque batterie partielle de condensateurs étant composée de plusieurs condensateurs juxtaposés, caractérisé par le fait que les semi-conducteurs de puissance sont disposés sur deux surfaces principales d'une barre de refroidissement (6) qui se trouve sur le côté frontal des batteries partielles de condensateurs, qu'un premier ensemble-barre longitudinal (9, 56) à plusieurs couches, s'étendant parallèlement aux surfaces principales de la barre de refroidissement, est relié à des connexions électriques de la première batterie partielle de condensateurs (4) et aux connexions électriques des premiers semi-conducteurs de puissance (7, 53) disposés sur la première surface principale de la barre de refroidissement, qu'un deuxième ensemble-barre longitudinal (10, 57) à plusieurs couches, s'étendant parallèlement aux surfaces principales de la barre de refroidissement, est relié aux connexions électriques de la deuxième batterie partielle de condensateurs (5) et aux connexions électriques des deuxièmes semi-conducteurs de puissance (8, 53) disposés sur la deuxième surface principale de la barre de refroidissement, et qu'un ensemble-barre transversal (11, 58) à plusieurs couches, s'étendant perpendiculairement aux ensembles-barres longitudinaux, relie les potentiels de tension continue des deux ensembles-barres longitudinaux, le système de barres de liaison composé des deux ensembles-barres longitudinaux et de l'ensemble-barre transversal ainsi que les deux batteries partielles de condensateurs s'étendant respectivement parallèlement à la barre de refroidissement.

2. Ensemble convertisseur suivant la revendication 1, caractérisé par le fait que les ensembles-barres longitudinaux (9, 10) présentent, outre les barres (22, 23, 31, 32) nécessaires pour la formation du circuit intermédiaire à courant continu, des barres supplémentaires (24, 33) pour la formation de connexions de charge.

3. Ensemble convertisseur suivant la revendication 2, caractérisé par le fait que l'ensemble-barre transversal (11) comprend des barres supplémentaires pour la formation de connexions de charge.

4. Ensemble convertisseur suivant l'une des revendications 1 à 3, caractérisé par le fait que les ensembles-barres longitudinaux (9, 10, 56, 57) et l'ensemble-barre transversal (11, 58) sont réalisés en continu d'une seule pièce.

5. Ensemble convertisseur suivant l'une des revendications 1 à 3, caractérisé par le fait que les liaisons électriques entre les ensembles-barres longitudinaux (9, 10) et l'ensemble-barre transversal (11) s'effectuent par des systèmes à vis (36).

6. Ensemble convertisseur suivant l'une des revendications 1 à 5, caractérisé par le fait que le système de barres de liaison est réalisé sous forme de système sandwich, composé de plusieurs barres (22 à 24, 31 à 35) électriquement conductrices séparées les unes des autres par des couches isolantes (25, 26, 37).

7. Ensemble convertisseur suivant l'une des revendications 1 à 6, caractérisé par le fait que le système de barres de liaison présente des pattes frontales (59) pour la connexion externe.

8. Ensemble convertisseur suivant l'une des revendications 1 à 7, caractérisé par le fait que les connexions électriques des semi-conducteurs de puissance (7, 8, 53) seront reliées par des intercalaires (28) au système de barres de liaison.

9. Ensemble convertisseur suivant l'une des revendications 1 à 7, caractérisé par le fait que les connexions électriques des semi-conducteurs de puissance sont reliées par des emboutis au système de barres de liaison.

10. Ensemble convertisseur suivant l'une des revendications 1 à 9, caractérisé par un boîtier composé d'une plaque de fond (1) avec des supports de condensateurs (2, 3) et des supports de barre de refroidissement (16, 17).
